# EUROPEAN PATENT SPECIFICATION

(11) **EP 1 143 534 B1**
(45) Date of publication and mention of the grant of the patent: **26.05.2004**
(21) Application number: 01107501.7
(22) Date of filing: 26.03.2001
(51) Int. Cl.: H01L 41/083, H01L 41/047

(54) **Multilayer piezoelectric actuator with electrodes reinforced in conductivity**
Vielschicht-Piezoaktor mit Elektroden mit verstärkter Leitfähigkeit
Actionneur piézo-électrique avec électrodes à conductivité renforcée

(30) Priority: 29.03.2000 JP 2000092201
(43) Date of publication of application: 10.10.2001
(73) Proprietor: NEC TOKIN CERAMICS CORPORATION, Shiso-gun, Hyogo (JP)
(72) Inventor: Takao, Fumio, Yamasaki-cho, Shiso-gun, Hyogo (JP); Kosaka, Hideaki, Yamasaki-cho, Shiso-gun, Hyogo (JP); Ogura, Narumi, Yamasaki-cho, Shiso-gun, Hyogo (JP); Matsukawa, Kazunobu, Yamasaki-cho, Shiso-gun, Hyogo (JP)
(74) Representative: Prüfer, Lutz H., Dipl.-Phys.

(56) References cited:
- US-A- 5 438 232
- US-A- 5 523 645
- PATENT ABSTRACTS OF JAPAN vol. 1997, no. 01, 31 January 1997 (1997-01-31) & JP 08 242025 A (HITACHI METALS LTD), 17 September 1996 (1996-09-17) -& JP 08 242025 A (HITACHI METALS LTD) 17 September 1996 (1996-09-17)
- PATENT ABSTRACTS OF JAPAN vol. 016, no. 291 (E-1224), 26 June 1992 (1992-06-26) -& JP 04 076969 A (NEC CORP), 11 March 1992 (1992-03-11)

## Description

### Background of the Invention

This invention relates to a multilayer piezoelectric actuator device comprising a laminated structure including a plurality of piezoelectric layers and a plurality of internal electrode layers alternately stacked and, in particular, to a multilayer piezoelectric actuator device comprising an external electrode connected to the internal electrodes.

JP 04076969 shows an electrostrictive effect element consisting of piled up electrostrictive sheets. On the side faces of the laminated body a first-layer external electrode is formed of a high-temperature-sintering-type conductive paste. On the first-layer external electrode a second-layer external electrode is formed of a resin-hardening-type conductive paste.

US 5,438,232 describes a piezoelectric lamination actuator, where metal straps, made of SUS304, 42Ni are glued onto sputtered thin-film external electrodes by a conductive adhesive agent or a non-conductive adhesive agent like epoxy resin.

JP 08242025 discloses a piezoelectric actuator with a plurality of stacked piezoelectric elements. Piezoelectric element coupling electrodes having a thin plate form and made of a conducting material having elasticity are adhered along surfaces of the electrode leads of this piezoelectric element pillar with conductive adhesives.

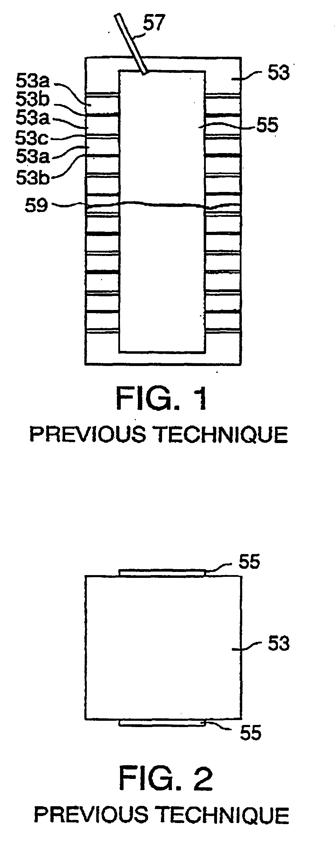

Referring to Figs. 1 and 2, a conventional multilayer piezoelectric actuator device will be described. The multilayer piezoelectric actuator device illustrated in Figs. 1 and 2 comprises a laminated structure 53 including a plurality of piezoelectric ceramics layers 53a and a plurality of internal electrodes 53b alternately laminated or stacked, a pair of external electrodes 55 formed on opposite side surfaces of the laminated structure 53 and connected alternately to the internal electrodes 53b, and a pair of external lead wires 57 connected to the external electrodes 55, respectively. On each of the opposite side surfaces of the laminated structure 53, the internal electrodes 53b are alternately covered with insulating glass coatings 53c and alternately uncovered or exposed. Therefore, the internal electrodes 53b are alternately electrically insulated from and alternately electrically connected to each of the external electrodes 55. In other words, the internal electrodes 53b are connected alternately to one and the other of the external electrodes 55. The external electrodes 55 are made of, for example, Ag (silver) or Ag/Pd (palladium).

In the multilayer piezoelectric actuator device mentioned above, the laminated structure 53 repeats quick extension and contraction when the actuator device is driven. This results in occurrence of fatigue in the piezoelectric ceramics layers 53a and the external electrodes 55. If the actuator device is driven for a long period of time, a crack 59 may be produced as illustrated in Fig. 1 and, in the worst case, the external electrodes 55 will be tom off. It is noted here that each of the external lead wires 57 is connected to the external electrode 55 only at an upper part of the laminated structure 53. Therefore, if the external electrode 55 is tom off, a lower part of the laminated structure 53 is no longer operable.

### Summary of the Invention:

It is therefore an object of this invention to provide a multilayer piezoelectric actuator device capable of suppressing degradation In function even if it is driven for a long period of time.

The object is achieved by a multilayer piezoelectric actuator device according to claim 1.

Further developments are described in the subclaims.

### Brief Description of the Drawing:

Fig. 1 is a front view of a conventional multilayer piezoelectric actuator device;
Fig. 2 is a bottom view of the conventional multilayer piezoelectric actuator device illustrated in Fig. 1;
Fig. 3 is a front view of a multilayer piezoelectric actuator device according to a first embodiment of this invention;
Fig. 4 is a bottom view of the multilayer piezoelectric actuator device illustrated in Fig. 3;
Fig. 5 is a sectional view taken along a line V-V in Fig. 3;
Fig. 6 is a front view of a multilayer piezoelectric actuator device according to a second embodiment of this invention;
Fig. 7 is a bottom view of the multilayer piezoelectric actuator device illustrated in Fig. 6;
Fig. 8 is a front view of a multilayer piezoelectric actuator device according to a third embodiment of this invention;
Fig. 9 is a bottom view of the multilayer piezoelectric actuator device illustrated in Fig. 8;
Fig. 10 is a front view of a multilayer piezoelectric actuator device according to a fourth embodiment of this invention; and
Fig. 11 is a bottom view of the multilayer piezoelectric actuator device illustrated in Fig. 10.

### Description of the Preferred Embodiments:

Now, description will be made of several preferred embodiments of this invention with reference to the drawing.

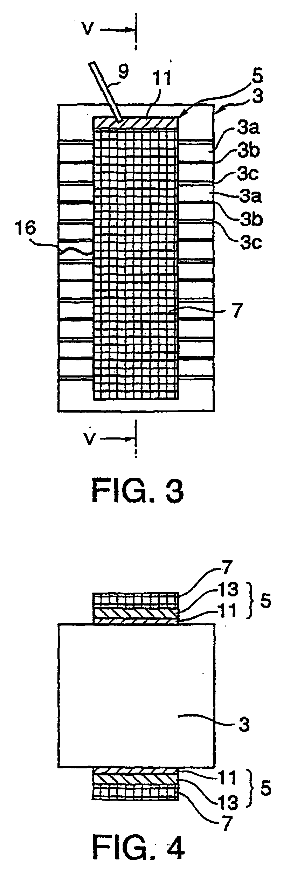

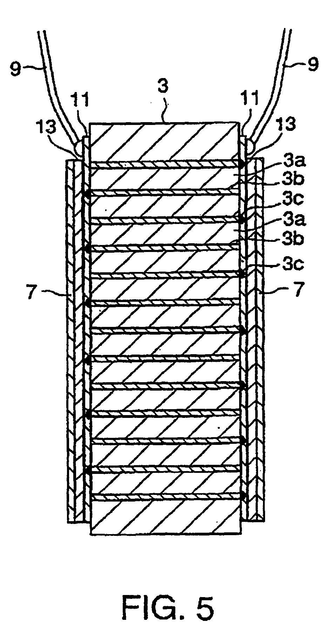

At first referring to Figs. 3 through 5, a multilayer piezoelectric actuator device according to a first embodiment of this invention comprises a laminated structure 3 including a plurality of plate-like piezoelectric ceramics layers or piezoelectric elements 3a and a plurality of plate-like internal electrodes 3b alternately stacked, a pair of external electrodes 5 connected to the internal electrodes 3b on opposite side surfaces of the laminated structure 3, a pair of carbon papers 7 placed on the external electrodes 5, respectively, and a pair of external lead wires 9 connected to the external electrodes 5, respectively. On each of the opposite side surfaces of the laminated structure 3, the internal electrodes 3b are alternately covered with insulating glass coatings 3c and alternately uncovered or exposed. Therefore, the internal electrodes 3b are alternately electrically insulated from and alternately electrically connected to each of the external electrodes 5. In other words, the internal electrodes 3b are connected alternately to one and the other of the external electrodes 5. The external electrodes 5 are formed, for example, by firing Ag (silver) or Ag/Pd (palladium).

Each of the external electrodes 5 comprises an electrode layer 11 formed by firing, plating, or sputtering on each of the opposite side surfaces of the laminated structure 3 and a first composite layer 13 formed on the electrode layer 11. The electrode layer 11 is formed, for example, by firing Ag (silver) or Ag/Pd (palladium). The first composite layer 13 is a conductive resin layer including a first conductive material. The first conductive material is made of at least one selected from Ag, Au, Pt, Pd, Cu, Ni, and C and has a fiber-like shape. The first composite layer 13 serves to adhere the carbon paper 7 to the electrode layer 11. The external lead wire 9 is connected to one end face of the electrode layer 11.

Next, description will be made in detail about a method of producing the above-mentioned multilayer piezoelectric actuator device.

At first, preparation is made of the laminated structure 3 having a size of 5mm x 5mm x 60mm with the internal electrodes 3b alternately exposed on the opposite side surfaces. On each of the opposite side surfaces of the laminated structure 3, screen-printing using a silver paste is carried out with 2mm wide and 50mm long in order to form the electrode layer 11. Thereafter, firing is carried out to form the electrode layer 11. On the electrode layer 11, the first composite layer 13 is formed. The carbon paper 7 having the width of 4mm, the length of 50mm, and the thickness of 300 µm is placed on the first composite layer 13. Successively, the first composite layer 13 is heat treated to be set or cured so that the carbon paper 7 is adhered to the electrode layer 11. Finally, the external lead wire 5 is connected to one end of the electrode layer 11.

The multilayer piezoelectric actuator device is driven, for example, by supplying a rectangular wave signal of 0-150V and 1 kHz to the external lead wires 5. In this case, if the actuator device is repeatedly driven a large number of times, for example, 10⁹ times, a crack 16 as illustrated in Fig. 3 may be produced due to the fatigue of each of the piezoelectric ceramics layers 3a and each of the electrode layers 11. In the worst case, such crack 16 may completely tear off the electrode layer 11. However, the first composite layer 13 as the conductive resin layer has a large extensibility and therefore keeps a conductive state without being tom off. Therefore, the multilayer piezoelectric actuator device is prevented from being degraded in function. In other words, the multilayer piezoelectric actuator device is improved in durability of the external electrodes 5.

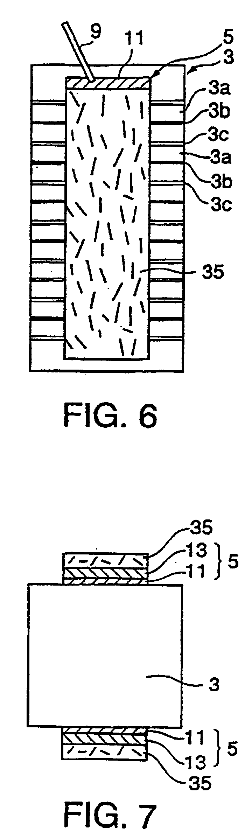

Referring to Figs. 6 and 7, a multilayer piezoelectric actuator device according to a second embodiment of this invention will be described. Similar parts are designated by like reference numerals and will no longer be described.

In the multilayer piezoelectric actuator device illustrated in Figs. 6 and 7, the carbon paper 7 used in the multilayer piezoelectric actuator device in Figs. 3 to 5 is replaced by a second composite layer 35 having a conductivity and attached to the external electrode 5. The second composite layer 35 is made of a composite material including a carbon fiber, a second conductive material having a fiber-like shape, and thermosetting resin. As a shape of the second conductive material, use is made of a fiber-like shape. The second conductive material is made of at least one kind of material selected from Ag, Au, Pt, Pd, Cu, Ni, and C. In the multilayer piezoelectric actuator 31 mentioned above, the external electrodes 5 are similarly improved in durability.

Referring to Figs, 8 and 9, description will be made of a multilayer piezoelectric actuator device. Similar parts are designated by like reference numerals and will no longer be described.

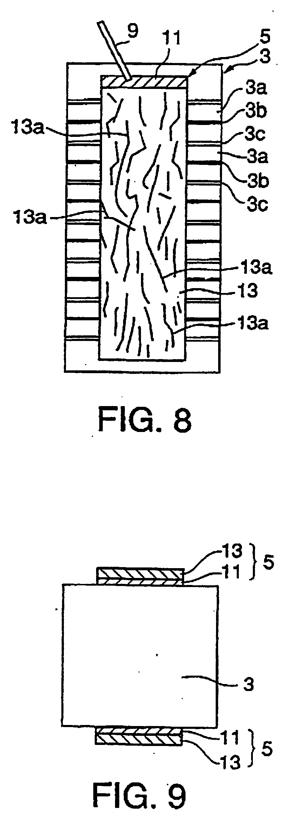

In the multilayer piezoelectric actuator device illustrated in Figs. 8 and 9, the first composite layer 13 is a conductive resin layer including conductive materials 13a as the first conductive material which are made of at least one kind of material selected from Ag, Au, Pt, Pd, Cu, Ni, and C. Each of the conductive materials 13a has a fiber-like shape extending relatively long in a laminate direction of the laminated structure 3. In the multilayer piezoelectric actuator device, the carbon paper and the second composite layer are not used.

Thus, since the first composite layer 13 includes the conductive materials each having a fiber-like shape and extending relatively long, the conductivity of the external electrode 5 can be maintained by the first composite layer 13 even if the electrode layer 11 is cracked or tom off.

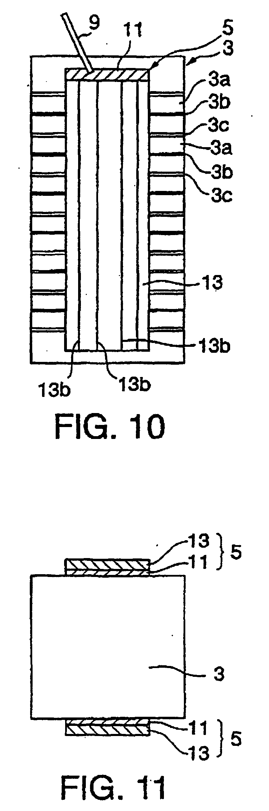

Referring to Figs. 10 and 11, description will be made of a multilayer piezoelectric actuator device according to a fourth embodiment of this invention. Similar parts are designated by like reference numerals and will no longer be described.

In the multilayer piezoelectric actuator device illustrated in Figs. 10 and 11, the first composite layer 13 is a conductive resin layer including conductive materials 13b as the first conductive material which are made of at least one kind of material selected from Ag, Au, Pt, Pd, Cu, Ni, and C. Each of the conductive materials 13b is formed as a fiber extending very long in the laminate direction of the laminated structure 3. In this embodiment, the carbon paper and the second composite layer are not used.

Thus, since the first composite layer 13 includes the fiber-like conductive material extending very long in the laminate direction of the laminated structure 3, the conductivity of the external electrode 5 can be maintained by the first composite layer 13 even if the electrode layer 11 is cracked or tom off.

As described above, with the multilayer piezoelectric actuator device of this invention, the electrical conductivity can be maintained by the conductive resin layer even if a crack is produced in the electrode layer of the external electrode. Therefore, durability and reliability can be improved. Even if the actuator device is driven for a long period of time, the degradation in function can be suppressed.

## Claims

1. A multilayer piezoelectric actuator device comprising a laminated structure (3) including a plurality of piezoelectric elements (3a) and a plurality of internal electrodes (3b) alternately stacked, and a pair of external electrodes (5) connected alternately to said internal electrodes, **characterized in that** each of said external electrodes comprises an electrode layer (11) formed on a side surface of said laminated structure and a first composite layer (13) formed on said electrode layer and made of a conductive resin including a first conductive material having a fiber-like shape.

2. The multilayer piezoelectric actuator device as claimed in claim 1, wherein said electrode layer is formed on the side surface of said laminated structure by one selected from firing, plating, and sputtering.

3. The multilayer piezoelectric actuator device as claimed in claim 1, wherein said first composite layer is adhered to said electrode layer by thermosetting.

4. The multilayer piezoelectric actuator device as claimed in any one of claims 1-3, further comprising a carbon paper (7) placed on said first composite layer, said electrode layer and said carbon paper being adhered to each other by said first composite layer.

5. The multilayer piezoelectric actuator device as claimed in any one of claims 1-3, further comprising a second composite layer (35) formed on said first composite layer, said second composite layer being made of a conductive resin including a second conductive material and a carbon fiber.

6. The multilayer piezoelectric actuator device as claimed in claim 5, wherein said electrode layer and said second composite layer are adhered to each other by said first composite layer.

7. The multilayer piezoelectric actuator device as claimed in claim 5 or 6, wherein said-second conductive material comprises at least one kind of material selected from Ag, Au, Pt, Pd, Cu, Ni, and C.

8. The multilayer piezoelectric actuator device as claimed in any one of claims 5-7, wherein said second conductive material has at least one kind of shape selected from a granular shape, a needle-like shape, and a fiber-like shape.

9. The multilayer piezoelectric actuator device as claimed in any one of claims 1-8, wherein said first conductive material comprises at least one kind of material selected from Ag, Au, Pt, Pd, Cu, Ni, and C.

## Patentansprüche

1. Mehrschichtige piezoelektrische Aktorvorrichtung mit
einer geschichteten Struktur (3), die eine Mehrzahl von piezoelektrischen Elementen (3a) und eine Mehrzahl von internen Elektroden (3b) enthält, die abwechselnd geschichtet sind, und
einem Paar von externen Elektroden (5), die abwechselnd mit den internen Elektroden verbunden sind,
**dadurch gekennzeichnet, dass**
jede der externen Elektroden aufweist:
eine Elektrodenschicht (11), die an einer Seitenfläche der geschichteten Struktur ausgebildet ist, und
eine erste Verbundschicht (13), die auf der Elektrodenschicht ausgebildet ist und aus einem Leitharz besteht, das ein erstes leitfähiges Material mit einer faserartigen Form enthält.

2. Mehrschichtige piezoelektrische Aktorvorrichtung nach Anspruch 1, bei der die Elektrodenschicht an der Seitenfläche der geschichteten Struktur durch ein aus Feuern, Plattieren und Sputtern ausgewähltes gebildet wird.

3. Mehrschichtige piezoelektrische Aktorvorrichtung nach Anspruch 1, bei der die erste Verbundschicht durch Wärmeaushärten an der Elektrodenschicht anhaftet.

4. Mehrschichtige piezoelektrische Aktorvorrichtung nach einem der Ansprüche 1 bis 3, weiter mit einem Kohlepapier (7), das auf der ersten Verbundschicht angeordnet ist, wobei die Elektrodenschicht und das Kohlepapier über die erste Verbundschicht aneinander haften.

5. Mehrschichtige piezoelektrische Aktorvorrichtung nach einem der Ansprüche 1 bis 3, weiter mit einer zweiten Verbundschicht (35), die auf der ersten Verbundschicht angeordnet ist, wobei die zweite Verbundschicht aus einem Leitharz besteht, das ein zweites leitendes Material und eine Kohlefaser enthält.

6. Mehrschichtige piezoelektrische Aktorvorrichtung nach Anspruch 5, bei der die Elektrodenschicht und die zweite Verbundschicht über die erste Verbundschicht aneinander haften.

7. Mehrschichtige piezoelektrische Aktorvorrichtung nach Anspruch 5 oder 6, bei der das zweite leitende Material zumindest eine Art von Material enthält, die aus Ag, Au, Pt, Pd, Cu, Ni und C ausgewählt ist.

8. Mehrschichtige piezoelektrische Aktorvorrichtung nach einem der Ansprüche 5 bis 7, der das zweite leitende Material zumindest eine Art von Form aufweist, die aus einer Kornform, einer nadelartigen Form und einer faserartigen Form ausgewählt ist.

9. Mehrschichtige piezoelektrische Aktorvorrichtung nach einem der Ansprüche 1 bis 8, der das erste leitende Material zumindest eine Art von Material enthält, die aus Ag, Au, Pt, Pd, Cu, Ni und C ausgewählt ist.

## Revendications

1. Dispositif actionneur piézo-électrique multicouche comprenant une structure stratifiée (3) incluant une pluralité d'éléments piézo-électriques (3a) et une pluralité d'électrodes internes (3b) empilées alternativement, ainsi qu'une paire d'électrodes externes (5) connectées alternativement aux éléments internes,
**caractérisé en ce que**
chacune des électrodes externes comprend une couche d'électrode (11) formée sur une surface latérale de la structure stratifiée, et une première couche composite (13) formée sur la couche d'électrode et réalisée dans une résine conductrice comprenant un premier matériau conducteur en forme de fibres.

2. Dispositif actionneur piézo-électrique multicouche selon la revendication 1,
dans lequel
la couche d'électrode est formée sur la surface latérale de la structure stratifiée par un procédé sélectionné parmi la cuisson, le placage et l'étincelage.

3. Dispositif actionneur piézo-électrique multicouche selon la revendication 1,
dans lequel
la première couche composite est collée à la couche d'électrode par thermodurcissement.

4. Dispositif actionneur piézo-électrique multicouche selon l'une quelconque des revendications 1 à 3,
comprenant en outre
un papier au carbone (7) placé sur la première couche composite, la couche d'électrode et le papier au carbone étant collés l'un à l'autre par la première couche composite.

5. Dispositif actionneur piézo-électrique multicouche selon l'une quelconque des revendications 1 à 3,
comprenant en outre
une seconde couche composite (35) formée sur la première couche composite. la seconde couche composite étant réalisée dans une résine conductrice incluant un second matériau conducteur et une fibre de carbone.

6. Dispositif actionneur piézo-électrique multicouche selon la revendication 5,
dans lequel
la couche d'électrode et la seconde couche composite sont collées l'une à l'autre par la première couche composite.

7. Dispositif actionneur piézo-électrique multicouche selon l'une quelconque des revendications 5 ou 6.
dans lequel
le second matériau conducteur comprend au moins un type de matériau sélectionné parmi Ag, Au. Pt, Pd, Cu, Ni, et C.

8. Dispositif actionneur piézo-électrique multicouche selon l'une quelconque des revendications 5 à 7,
dans lequel
le second matériau conducteur présente au moins un genre de forme sélectionné parmi une forme granulaire, une forme d'aiguilles et une forme de fibres.

9. Dispositif actionneur piézo-électrique multicouche selon l'une quelconque des revendications 1 à 8,
dans lequel
le premier matériau conducteur comprend au moins un type de matériau sélectionné parmi Ag, Au, Pt, Pd, Ni, et C.
